# FASCICULE DE BREVET EUROPEEN

(11) **EP 2 705 531 B1**
(45) Date de publication et mention de la délivrance du brevet: **14.11.2018**
(21) Numéro de dépôt: 12718241.8
(22) Date de dépôt: 04.05.2012
(51) Int. Cl.: H01L 23/538, H01L 21/60, H01L 23/48, H01L 23/31, H01L 21/56

(54) **PROCEDE DE FABRICATION DE PLAQUES RECONSTITUEES AVEC MAINTIEN DES PUCES PENDANT LEUR ENCAPSULATION**
VERFAHREN ZUR HERSTELLUNG VON REKONSTITUIERTEN WAFERN MIT UNTERSTÜTZUNG DER CHIPS WÄHREND IHRER VERKAPSELUNG
PROCESS FOR FABRICATING RECONSTITUTED WAFERS WITH SUPPORT OF THE CHIPS DURING THEIR ENCAPSULATION

(30) Priorité: 06.05.2011 FR 1153902
(43) Date de publication de la demande: 12.03.2014
(73) Titulaire: 3D Plus, 78530 Buc (FR)
(72) Inventeur: VAL, Christian, F-78470 Saint Remy Les Chevreuse (FR)
(74) Mandataire: Henriot, Marie-Pierre
(86) Numéro de dépôt international: PCT/EP2012/058195
(87) Numéro de publication internationale: WO 2012/152672

(56) Documents cités:
- FR-A1- 2 843 485
- JP-A- 59 040 542
- US-A1- 2008 265 421
- US-A1- 2010 006 988
- US-A1- 2011 024 894
- US-A1- 2011 278 703

## Description

Le domaine de l'invention est celui de la fabrication de plaques (ou « wafers » en anglais) reconstituées qui comprennent des puces encapsulées dans une résine, ces puces ayant en général été préalablement testées.

La solution la plus couramment mise en oeuvre pour réaliser une plaque reconstituée consiste tout d'abord à découper des plaques sur lesquelles des puces ont été fabriquées pour obtenir des puces individuelles, une plaque produisant un premier type de puces ou « chips » identiques entre elles, une autre plaque produisant un autre type de puces, etc. On désigne par puce un composant électronique actif tel qu'une puce nue ou un composant passif (condensateurs, résistances, transformateurs ou inductances, ...) ou un MEMS, acronyme de l'expression anglo-saxonne « Micro Electro Mechanical System ». Généralement, ces puces sont alors sélectionnées après avoir été testées et souvent désignées « Known Good Die ».

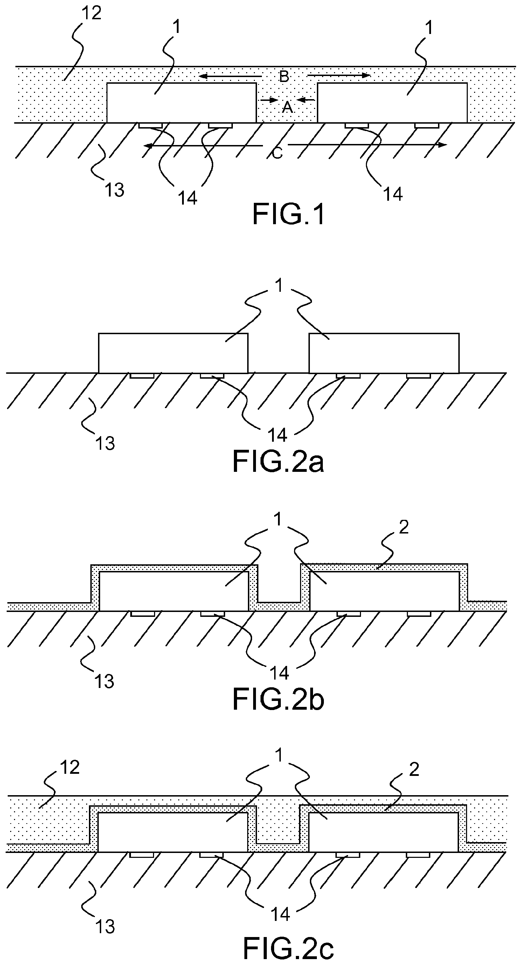

Les différents types de puces 1 testées, qui présentent des plots de connexion 14 sur une face dite face active ou face avant, sont alors prélevées et positionnées face avant sur un support adhésif 13 comme montré sur la figure 2a, au moyen par exemple d'une machine « pick-and-place » pour former des motifs de puces généralement semblables les uns aux autres. On désigne par motif de puces, un groupe de différentes puces destinées à former un élément électronique.

Ce support adhésif 13 est typiquement une peau collante elle-même collée à un support rigide. Puis les puces sont encapsulées dans une résine 12 polymère de type Epoxy afin de les solidariser.

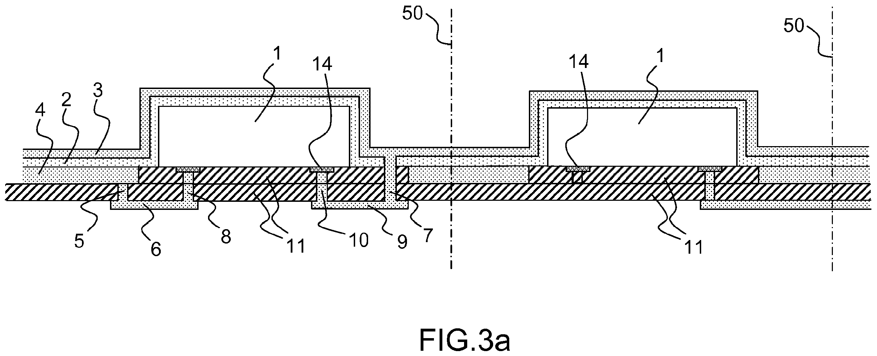

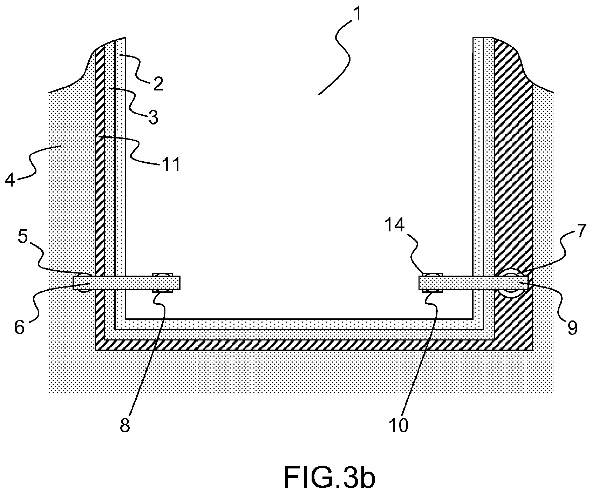

Une couche de redistribution ou RDL acronyme de l'expression anglo-saxonne « ReDistribution Layer » éventuellement à plusieurs étages, est ensuite formée du côté face avant, après retrait du support adhésif 13 et de la peau collante ; cette couche RDL qui comprend des pistes en TiW/Cu ou en TiPd/Au par exemple, est formée sur une couche diélectrique 11 déposée à la place du support adhésif, par trempage ou par centrifugation, et qui est représentée sur les figures 3, 4 et 5. La plaque ainsi reconstituée qui ne comporte pas de puces défectueuses peut alors être découpée pour obtenir des micro boîtiers plastiques ; elle peut aussi être empilée sur d'autres plaques reconstituées, et électriquement connectée à ces plaques selon différents procédés connus, l'empilement étant ensuite découpé pour obtenir des modules électroniques à trois dimensions ou 3D.

L'encapsulation des puces comprend :
- une étape de dépôt de la résine (par coulage ou par moulage dit en compression), autour et éventuellement sur les puces collées sur le support adhésif, de manière à remplir les espaces inter-puces,
- une étape de polymérisation de la résine pour la durcir et ainsi former un substrat rigide et manipulable dans lequel sont fixées les puces, le substrat adhésif pouvant alors être retiré.

Un exemple de procédé de fabrication de plaques reconstituées qui comprennent des puces encapsulées dans une résine est décrit dans le document US 2011/024894.

Un inconvénient notoire est le déplacement des puces lors du dépôt de la résine et/ou lors de sa polymérisation, les plots des puces ne coïncidant alors plus avec les pistes de la couche de redistribution (couche RDL). Les micro déplacements des puces par rapport à la position prévue, illustrés figure 1, sont dus à :
- l'imprécision de positionnement des puces sur le support adhésif, qui est de l'ordre de 5 µm avec des équipements « pick-and-place » récents fonctionnant à grande vitesse,
- la dilatation réversible mais très élevée du support adhésif aux alentours de 100 ppm/°C, illustrée par les flèches C,
- le retrait irréversible de la résine lors de la polymérisation de l'ordre de quelques 1000 ppm/°C, illustré par les flèches A
- la dilatation réversible de la résine après polymérisation d'environ 16 à 17 ppm/°C, illustrée par les flèches B.

Il en résulte des micro déplacements plus ou moins isotropes et imprévisibles, typiquement compris entre quelques µm et quelques dizaines de µm, ce qui peut excéder les tolérances de positionnement (par rapport à la couche RDL) requises après moulage, qui sont typiquement de l'ordre de 10 µm.

Une solution consiste à étudier et enregistrer ces micro déplacements préalablement puis à les anticiper lors du positionnement des puces lorsqu'elles sont reportées sur le support adhésif. Une des limites de cette technique provient de ce que les micro déplacements ne sont pas tous prévisibles, notamment ceux des différents types de puces au sein d'un même motif.

Une autre solution existante consiste à disposer sur le support adhésif un treillis de cuivre à mailles rectangulaires de dimensions supérieures à la puce d'environ 1 à 1,5 mm, puis à reporter les puces sur le support dans les cavités situées entre les barreaux entrecroisés du treillis ; ce treillis est ainsi utilisé comme gabarit dans lequel on place les puces et permet de limiter le volume de résine entourant la puce donc de limiter localement le retrait après polymérisation. Ce procédé permet de réduire la dilatation et donc le déplacement des puces mais ne permet pas de l'éliminer puisque ceci ne règle pas le problème de la peau collante qui se déplace elle aussi. Dans tous les cas on corrige les masques permettant de réaliser les couches de redistribution. Après la réalisation des 3 ou 4 premiers « wafers » (ou plaques), les mesures de dérive des puces sont effectuées et les masques sont corrigés en conséquence. Il faut ensuite que les dérives soient toujours identiques et reproductibles. Il présente en outre les inconvénients suivants :
- le treillis reste obligatoirement dans le boîtier final puisqu'une fois moulé dans la résine, il ne peut plus être enlevé,
- cela limite le nombre de puces sur la plaque du fait de la place importante prise par le treillis,
- cela nécessite une double découpe pour faire disparaître les barreaux du treillis,
- la correction des masques donc de la position des pistes conductrices des couches de redistribution peut gêner l'empilage ultérieur des wafers reconstitués qui nécessitent un pas rigoureusement constant par construction.

On sait aussi corriger à la fois la position des puces lors du report de celles-ci sur la peau collante en modifiant le pas de pose sur les machines de « Pick and Place », et les masques utilisés pour la RDL. Pour les cas les plus critiques on insole puce par puce ce qui est très coûteux et ne permet pas de garantir le pas pour les étapes d'empilage.

La demanderesse a décrit une solution dans la demande de brevet WO2010/102996. Elle est basée sur l'utilisation d'une grille non pas autour des puces mais sur les puces de façon à fixer celles-ci en « position » fixe et non modifiable avant les étapes de moulage puis de polymérisation. Une grille provisoire en cuivre par exemple est collée à la température ambiante sur l'ensemble des faces arrière des puces. Après polymérisation à la température ambiante ou aux ultra-violets pour les colles dites UV, le coulage et la polymérisation peuvent être effectués sans déplacement des puces. La grille en cuivre est ensuite dissoute chimiquement ou l'ensemble de la face arrière du wafer reconstitué est abrasée mécaniquement. Les seuls inconvénients de cette technique sont dus au fait que des étapes supplémentaires de collage et de destruction de la grille provisoire sont nécessaires.

Le but de l'invention est de pallier cet inconvénient de déplacement des puces lors de leur encapsulation dans de la résine, sans recourir à ces étapes de collage et de destruction de la grille.

Selon l'invention le maintien des puces après l'étape de pose « Pick and Place » est obtenu par un dépôt en phase gazeuse à la température ambiante, de matériaux minéraux électriquement isolants. Ce dépôt peut rester pendant tout le procédé de fabrication de la plaque reconstituée, ou bien être partiellement dissous chimiquement.

Cette technique dite de « Dépôt par plasma atmosphérique » présente plusieurs avantages. Il s'agit d'une technique de dépôt chimique en phase gazeuse hors vide (à la pression atmosphérique) et à basse température (ambiante). Par ailleurs l'adhésion est excellente car le plasma utilisé permet de « nettoyer » la surface avant dépôt.

Plus précisément, l'invention a pour objet un procédé de fabrication collective d'une plaque reconstituée qui comporte des puces lesquelles sont soit un composant électronique actif tel qu'une puce nue ou un composant passif, présentant des plots de connexion sur une des faces de la puce dite face avant, ledit procédé comprenant les étapes suivantes :
A) positionnement des puces sur un support adhésif initial, face avant sur le support,
B) dépôt d'une couche minérale électriquement isolante sur le support initial et les puces,
caractérisé en ce que le dépôt de l'étape B est un dépôt en phase gazeuse à la pression atmosphérique et à la température ambiante, la couche minérale électriquement isolante ayant un rôle mécanique de maintien des puces, et en ce qu'il comprend les étapes supplémentaires :
C) transfert des puces recouvertes de la couche électriquement isolante minérale sur un support adhésif provisoire, face arrière des puces vers ce support adhésif provisoire,
D) retrait du support adhésif initial,
E) report des puces sur un support de type « wafer chuck » en acier percé de trous, faces avant des puces vers ce support,
F) retrait du support adhésif provisoire,
G) dépôt d'une résine sur le support de type « wafer chuck » pour encapsuler les puces, puis polymérisation de la résine,
H) retrait du support de type « wafer chuck »,
I) réalisation d'une couche de redistribution côté face active.

La couche électriquement isolante a un rôle mécanique de maintien des puces.

L'étape B) comprend suite au dépôt de la couche minérale électriquement isolante, une étape de dépôt en phase gazeuse à la pression atmosphérique et à la température ambiante, d'une première couche électriquement conductrice en contact avec la couche minérale électriquement isolante, et formant la première électrode d'un condensateur,
et l'étape de réalisation d'une couche de redistribution comporte préalablement les étapes suivantes :
- dépôt d'une couche hétérogène formée d'une partie électriquement isolante seulement en contact avec les faces actives des puces et d'une partie électriquement conductrice déposée côté face active de la plaque mais en dehors des faces actives des puces et qui forme la deuxième électrode en regard de la première électrode du condensateur,
- réalisation de pistes électriquement conductrices et de vias pour connecter la première électrode à un premier plot d'alimentation de la puce et la deuxième électrode à un autre plot d'alimentation de la puce.

L'électrode « RDL » peut être fractionnée en plusieurs électrodes, chaque fraction étant connectée à un autre plot d'alimentation électrique de la puce par un via percé dans l'isolant.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite illustre schématiquement les micro déplacements auxquels sont soumis les puces pendant leur encapsulation,
les figures 2 représentent schématiquement les principales étapes selon l'invention de dépôt d'une couche électriquement isolante sur la plaque (fig 2b) et d'encapsulation des puces (fig 2c),
les figures 3 illustrent schématiquement un exemple de mode de réalisation d'un condensateur à partir d'un dépôt successif de deux couches minérales, vu en coupe (fig 3a) et de dessous (fig 3b) selon l'invention ; la vue de dessous est représentée sans la (ou les) couche(s) isolant RDL.

D'une figure à l'autre, les mêmes éléments sont repérés par les mêmes références.

Le maintien des puces après l'étape de pose « Pick and Place » est obtenu par un (ou plusieurs) dépôt(s) en phase gazeuse à la pression atmosphérique et à la température ambiante, de matériaux minéraux électriquement isolants.

On décrit en relation avec les figures 2 les principales étapes du procédé.

De manière classique, les puces 1 sont reportées et positionnées sur un support adhésif 13 comportant une « peau collante », les faces avant comportant les plots de connexion 14 (aussi dites faces actives) étant sur ce support adhésif (figure 2a).

Selon l'invention, une couche électriquement isolante 2 de quelques microns (de 1 µm à 10 µm) est déposée sur l'ensemble du wafer reconstitué, c'est-à-dire sur les puces 1 et le support 13, à la température ambiante et à la pression atmosphérique (figure 2b).

Selon un premier mode de réalisation, une seule couche électriquement isolante 2 est déposée, telle que par exemple une couche de SiO2. Cela présente les avantages suivants :
- cette couche 2 reste et apporte ainsi une meilleure continuité mécanique avec les puces en silicium ;
- les piste conductrices d'interconnexion de la couche de redistribution « RDL » généralement en cuivre, auront des propriétés électriques meilleures que dans le cas de dépôt sur les matériaux polymères (utilisés pour les diélectriques) car la permittivité électrique de la silice est voisine de 3,8 comparée à celle des polymères permettant de réaliser les niveaux RDL qui est d'environ 4,5 à 5 ;
- par ailleurs, dans le cas de puces empilées devant être découplées thermiquement, une couche de quelques microns d'un matériau également isolant thermiquement comme la silice peut permettre de diminuer l'échange thermique entre deux puces superposées.

Les puces 1 étant ainsi maintenues en position grâce à cette couche 2, l'étape de moulage puis de polymérisation de la résine 12 peut intervenir (figure 2c). Le procédé standard consistant à couler ou à mouler par compression la résine, est utilisé. Le support adhésif 13 est alors décollé.

On sait que la température de polymérisation des résines 12 détermine leur comportement thermo mécanique en général. Ainsi, plus une résine de type époxyde est polymérisée à haute température (par exemple 220 °C au lieu de 140 °C) plus sa température de transition vitreuse (Tg) sera élevée. Or une couche minérale peut supporter ces plus hautes températures, ce qui n'est pas le cas d'une couche organique telle que celle des supports adhésifs. On va donc remplacer ce support adhésif par un support (« carrier ») classique non adhésif supportant ces températures élevées ; on utilise typiquement un support de plaque « wafer chuck » en acier percé de trous. On procède de la manière suivante. Un transfert des faces arrière des puces sur un support adhésif provisoire permet d'éliminer le support adhésif initial des faces actives et ainsi de replacer sous vide la plaque reconstituée sur le support de type « Chuck » (face active vers le « chuck »). Après le retrait du support adhésif provisoire, on peut alors couler la résine puis la polymériser à une haute température. On retire alors le support de type « chuck ».

Le procédé continue avec la réalisation de la couche dite RDL.

Selon un autre mode de réalisation, deux dépôts successifs d'une couche minérale sont combinés, ce qui permet notamment de renforcer le maintien des puces en position. Le fait de disposer dans l'ordre d'une couche électriquement isolante 2 et d'une couche conductrice 3 de cuivre par exemple permet en outre, en déposant les deux de construire un condensateur. On sait en effet que l'un des principaux problèmes des circuits rapides (microprocesseurs, mémoires etc...) est la distribution de l'énergie au plus près de la demande (en l'occurrence la puce) de façon à minimiser les inductances des pistes conductrices qui conduisent à des retards dans l'alimentation de ces circuits.

Le dépôt successif d'une couche électriquement isolante et d'une couche électriquement conductrice permet d'utiliser l'ensemble de la surface autour de chaque puce (ou une partie de celle-ci : le condensateur entoure la puce de préférence sur ses 4 côtés ; mais il peut ne l'entourer que sur un, deux 2 ou trois 3 côtés) et servant de support à l'interconnexion dite RDL, pour former un ou plusieurs condensateurs comme montré figures 3.

Selon ce mode de réalisation, après l'étape de dépôt par plasma atmosphérique d'une couche électriquement isolante 2 côté face arrière, un second dépôt par plasma atmosphérique d'une couche électriquement conductrice 3 sur cette couche 2 (côté face arrière), va permettre de constituer la première électrode 3 du condensateur. Après l'étape de moulage et de polymérisation de la résine, et préalablement à la réalisation de la RDL initialement prévue, une couche électriquement conductrice 4 est déposée côté face active de la plaque mais en dehors des faces actives des puces, pour réaliser la seconde électrode 4 en regard de la première, une couche électriquement isolante 11 dite isolant RDL étant déposée en contact avec les faces actives des puces comme on peut le voir sur la figure. On obtient ainsi une couche hétérogène formée d'une partie 4 électriquement conductrice et d'une partie 11 électriquement isolante.

Des trous ou « via » sont réalisés dans l'isolant RDL 11, de façon à connecter au plus court les deux électrodes 3 et 4 du condensateur aux alimentations électriques de la puce d'une part (il s'agit en l'occurrence de plots 14 d'alimentation électrique des puces) et aux alimentations électriques extérieures du condensateur d'autre part.

La seconde électrode 4 est connectée à une première piste électriquement conductrice 6, cette piste formée sur l'isolant RDL étant raccordée par un premier via 8 à un plot 14 de la puce correspondant à l'alimentation électrique de celle-ci. Comme on peut le voir figure 3a, cette seconde électrode 4 se prolonge sous la forme d'une piste jusqu'à une ligne de découpe 50 en prévision de l'interconnexion latérale (selon la dimension de l'empilement) d'un module 3D ; ou une piste est formée sur l'isolant RDL jusqu'à la ligne de découpe. Lorsqu'une autre couche électriquement isolante a été déposée sur la couche hétérogène comportant la seconde électrode 4 et l'isolant RDL 11, cette seconde électrode 4 est connectée à la première piste conductrice 6 par un deuxième via 5 traversant cette autre couche comme montré sur la figure 4, le premier via 8 traversant également cette autre couche.

Un troisième via 7 permet de connecter la première électrode 3 formée par la couche électriquement conductrice 3 avec une deuxième piste électriquement conductrice 9 reliant un quatrième via 10, cette piste étant raccordée à un second plot 14 d'alimentation électrique de la puce 1. Cette première électrode se prolonge sous la forme d'une piste jusqu'à une autre ligne de découpe 50 en prévision de l'interconnexion latérale (selon la dimension de l'empilement) du module 3D ; ou une piste est formée sur l'isolant RDL jusqu'à la ligne de découpe.

Pour le cas où plusieurs tensions électriques sont nécessaires, une électrode du condensateur peut être fractionnée en 2, 3 ou « n » parties afin de constituer autant de condensateurs qui sont connectés à d'autres plots d'alimentation électrique de la puce prévus pour cela, grâce à d'autres vias.

Les électrodes 3, 4 du condensateur étant ainsi connectées aux alimentations électriques de la puce et aux futures alimentations extérieures, la réalisation de la RDL prévue initialement peut alors être réalisée, son premier ou seul étage étant réalisé au niveau des pistes conductrices 6 et 9, ou 16 et 21.

## Revendications

1. Procédé de fabrication collective d'une plaque reconstituée qui comporte des puces (1) lesquelles sont soit un composant électronique actif tel qu'une puce nue ou un composant passif, présentant des plots de connexion (14) sur une des faces de la puce dite face avant, ledit procédé comprenant les étapes suivantes :
A) positionnement des puces (1) sur un support adhésif initial (13), face avant sur le support,
B) dépôt d'une couche minérale électriquement isolante (2) sur le support initial (13) et les puces (1),
**caractérisé en ce que** le dépôt de l'étape B est un dépôt en phase gazeuse à la pression atmosphérique et à la température ambiante, la couche minérale électriquement isolante (2) ayant un rôle mécanique de maintien des puces, et **en ce qu'**il comprend les étapes supplémentaires :
C) transfert des puces recouvertes de la couche minérale électriquement isolante sur un support adhésif provisoire, face arrière des puces vers ce support adhésif provisoire,
D) retrait du support adhésif initial (13),
E) report des puces sur un support de type « wafer chuck » en acier percé de trous, faces avant des puces vers ce support,
F) retrait du support adhésif provisoire,
G) dépôt d'une résine (12) sur le support de type «wafer chuck » pour encapsuler les puces, puis polymérisation de la résine,
H) retrait du support de type « wafer chuck »,
I) réalisation d'une couche de redistribution côté face active.

2. Procédé de fabrication collective d'une plaque reconstituée selon la revendication précédente, **caractérisé en ce que** la couche minérale électriquement isolante (2) est une couche de SiO2.

3. Procédé de fabrication collective d'une plaque reconstituée selon l'une des revendications précédentes, **caractérisé en ce que** l'étape B comprend suite au dépôt de la couche minérale électriquement isolante (2) :
- une étape de dépôt en phase gazeuse à la pression atmosphérique et à la température ambiante, d'une première couche minérale électriquement conductrice (3) en contact avec la couche minérale électriquement isolante (2), et formant la première électrode d'un condensateur,
et **en ce que** l'étape de la réalisation d'une couche de redistribution comporte préalablement les étapes suivantes :
- dépôt d'une couche hétérogène formée d'une partie électriquement isolante (11) seulement en contact avec les faces actives des puces (1) et d'une partie électriquement conductrice (4) déposée côté face active de la plaque mais en dehors des faces actives des puces et qui forme la deuxième électrode en regard de la première électrode du condensateur,
- réalisation de pistes électriquement conductrices (6, 9) et de vias (8, 10, 7) pour connecter la première électrode à un premier plot (14) d'alimentation de la puce et la deuxième électrode à un autre plot d'alimentation de la puce.

## Patentansprüche

1. Verfahren zur kollektiven Fertigung eines rekonstituierten Wafers, welcher Chips (1) beinhaltet, welche entweder eine aktive elektronische Komponente wie ein blanker Chip oder eine passive Komponente sind, welche Anschlusshöcker (14) auf einer der Seiten des Chips aufweisen, genannt Vorderseite, wobei das Verfahren folgende Schritte beinhaltet:
A) Positionieren der Chips (1) auf einem anfänglichen, haftenden Träger (13), mit der Vorderseite auf dem Träger,
B) Ablagern einer elektrisch isolierenden, mineralischen Schicht (2) auf dem anfänglichen Träger (13) und den Chips (1),
**dadurch gekennzeichnet, dass** die Ablagerung von Schritt B eine Ablagerung in der Gasphase bei Atmosphärendruck und Raumtemperatur ist, wobei die elektrisch isolierende mineralische Schicht (2) eine mechanische Rolle des Haltens der Chips spielt, und dadurch, dass sie folgende zusätzliche Schritte beinhaltet:
C) Transfer der mit der elektrisch isolierenden, mineralischen Schicht bedeckten Chips auf einen provisorischen haftenden Träger, mit der Rückseite der Chips zu diesem provisorischen, haftenden Träger,
D) Entfernen des anfänglichen, haftenden Trägers (13),
E) Übertragen der Chips auf einen Träger vom Typ "wafer chuck" aus mit Löchern versehenem Stahl, mit der Vorderseite der Chips zu diesem Träger,
F) Entfernen des provisorischen, haftenden Trägers,
G) Ablagern eines Harzes (12) auf dem Träger vom Typ "wafer chuck" zum Verkapseln der Chips, gefolgt von Polymerisieren des Harzes,
H) Entfernen des Trägers vom Typ "wafer chuck",
I) Herstellen einer Redistributionsschicht auf der aktiven Seite.

2. Verfahren zur kollektiven Fertigung eines rekonstituierten Wafers nach dem vorhergehenden Anspruch, **dadurch gekennzeichnet, dass** die elektrisch isolierende, mineralische Schicht (2) eine SiO2-Schicht ist.

3. Verfahren zur kollektiven Fertigung eines rekonstituierten Wafers nach einem der vorhergehenden Ansprüche, **dadurch gekennzeichnet, dass** der Schritt B nach dem Ablagern der elektrisch isolierenden mineralischen Schicht (2) Folgendes beinhaltet:
- einen Schritt des Ablagerns, in der Gasphase bei Atmosphärendruck und bei Raumtemperatur, einer ersten elektrisch leitenden, mineralischen Schicht (3) in Kontakt mit der elektrisch isolierenden, mineralischen Schicht (2) und welche die erste Elektrode eines Kondensators bildet,
und dadurch, dass der Schritt des Herstellens einer Redistributionsschicht zuvor folgende Schritte beinhaltet:
- Ablagern einer heterogenen Schicht, gebildet aus einem elektrisch isolierenden Teil (11), welcher nur in Kontakt mit den aktiven Seiten der Chips (1) steht, und einem elektrisch leitenden Teil (4), welcher auf der aktiven Seite des Wafers abgelagert wird, jedoch außerhalb der aktiven Seiten der Chips und welcher die zweite Elektrode gegenüber der ersten Elektrode des Kondensators bildet,
- Herstellen von elektrisch leitenden Spuren (6, 9) und Durchgangsleitungen (8, 10, 7) zum Anschließen der ersten Elektrode an einen ersten Speisungshöcker (14) zur Speisung des Chips und der zweiten Elektrode an einen anderen Speisungshöcker des Chips.

## Claims

1. A method for collectively fabricating a reconstituted wafer which comprises chips (1) which are either an active electronic component such as a bare chip or a passive component exhibiting connection pads (14) on one of the faces of the chip termed the front face, said method comprising the following steps:
A) positioning of the chips (1) on an initial adhesive support (13), front face on the support,
B) deposition of an electrically insulating mineral layer (2) on the initial support (13) and the chips (1),
**characterized in that** the deposition in step B is a vapor-phase desposition at atmospheric pressure and at ambient temperature, the electrically insulating mineral layer (2) having a mechanical role of holding the chips, and **in that** it comprises the additional steps:
C) transfer of the chips covered with the electrically insulating mineral layer onto a provisional adhesive support, rear face of the chips toward this provisional adhesive support,
D) removal of the initial adhesive support (13),
E) overlaying of the chips onto a steel support of "wafer chuck" type drilled with holes, front faces of the chips toward this support,
F) removal of the provisional adhesive support,
G) deposition of a resin (12) on the support of "wafer chuck" type so as to encapsulate the chips, and then polymerization of the resin,
H) removal of the support of "wafer chuck" type,
I) production of an RDL layer active face side.

2. The method for collectively fabricating a reconstituted wafer according to the preceding claim, **characterized in that** the electrically insulating mineral layer (2) is a layer of SiO2.

3. The method for collectively fabricating a reconstituted wafer according to any of the preceding claims, **characterized in that** step B furthermore comprises following the deposition of the electrically insulating mineral layer (2):
- a step of vapor deposition at atmospheric pressure and at ambient temperature, of a first electrically conducting mineral layer (3) in contact with the electrically insulating mineral layer (2), and forming the first electrode of a capacitor,
and **in that** the RDL step comprises the following steps beforehand:
- deposition of a heterogeneous layer formed of an electrically insulating part (11) in contact only with the active faces of the chips (1) and of an electrically conducting part (4) deposited on the active face side of the wafer but away from the active faces of the chips and which forms the second electrode opposite the first electrode of the capacitor,
- production of electrically conducting tracks (6, 9) and vias (8, 10, 7) so as to connect the first electrode to a first power supply pad (14) of the chip and the second electrode to another power supply pad of the chip.
